# EUROPÄISCHE PATENTSCHRIFT

(11) **EP 1 226 943 B1**
(45) Veröffentlichungstag und Bekanntmachung des Hinweises auf die Patenterteilung: **29.04.2009**
(21) Anmeldenummer: 02000910.6
(22) Anmeldetag: 16.01.2002
(51) Int. Cl.: B41F 33/00

(54) **Steuereinrichtung für eine Druckmaschine**
Control device for a printing press
Dispositif de commande pour une machine à imprimer

(30) Priorität: 30.01.2001 DE 20101512 U
(43) Veröffentlichungstag der Anmeldung: 31.07.2002
(73) Patentinhaber: manroland AG, 63075 Offenbach/Main (DE)
(72) Erfinder: Gösswein, Hermann, 63773 Goldbach (DE); Muth, Christopher, 63615 Mühlheim (DE)
(74) Vertreter: Stahl, Dietmar

(56) Entgegenhaltungen:
- DE-U- 29 919 792
- BERND TIBURTIUS: "Transparente Folientastaturen" FEINWERKTECHNIK & MESSTECHNIK, Bd. 97, Nr. 7, 1. Juli 1989 (1989-07-01), Seiten 299-300, XP000037606 Munchen

## Beschreibung

Die Erfindung betrifft eine Druckmaschine mit einer Steuereinrichtung gemäß dem Oberbegriff von Anspruch 1.

Die Steuerung von Druckmaschinen erfolgt zum Teil direkt an der Maschine. Es ist bekannt, dass Bedienelemente zum Ändern der Einstellung um durchsichtige Scheiben angeordnet sein können (Offsetdruck Polygraph-Handbuch von W. Walenski, 1991, S.83). Die Scheiben dienen der visuellen Überwachung von Vorgängen innerhalb der Druckmaschine.

Die Bedien- und Anzeigeelemente sind nötig, um direkt in den Druckprozess eingreifen zu können. Die Bedienelemente sind meist über den Scheiben angeordnet. Der Maschinenbediener muss den Blick vom Druckprozess, den er durch die Scheibe beobachten kann, abwenden, wenn er an der Einstellung der Druckmaschine etwas verändern will. Meist muss er sich auch strecken um von seiner Position an die Bedienelemente heranzukommen oder sogar seine Position verlassen. Das erschwert das Bedienen der Druckmaschine.

Weiterhin ist eine Dateneingabeeinrichtung an Druckmaschinen durch die DE 32 20 622 A1 bekannt. Diese Einrichtung besteht aus einem Bildschirm, der mit einer druckempfindlichen, durchsichtigen Schicht überzogen ist und somit die Bedienelemente direkt am Bildschirm angeordnet werden können. Nachteilig hierbei ist, dass nur ein Monitorbild angezeigt werden kann.

Aus der DE- Zeitschrift "Elektrotechnik - Das Automatisierungs-Magazin" Ausgabe 12-2000 S.6 ist ein sogenanntes Powerglas bekannt. Powerglas ist eine leitend beschichtete Glasoberfläche, in welchem die Zuleitungen zum bestückten Bauteil unsichtbar bleiben. Der Aufbau eines durchsichtigen Displays ist in der DE-Z "Elektronik" 3/1999; Seite 24 unter "Strom unter Glas" beschrieben.

Aus der DE 299 19 792 U1 ist eine Bedieneinheit zum Bedienen von im Wesentlichen elektrisch bedienbaren Vorrichtungen und/oder Geräten bekannt. Die Bedieneinheit enthält wenigstens ein transparentes Druckschaltelement, dessen Bedienfläche von einer Dünnglasscheibe gebildet ist. Als Anzeigeelement wird hierzu dem Bedienelement ein Hintergrundbildschirm als Flachbildschirm hinterlegt.

Aufgabe der vorliegenden Erfindung ist es daher, eine Druckmaschine mit einer Steuereinrichtung gemäß dem Oberbegriff von Anspruch 1 derartig zu erweitern, dass eine einfache Bedienbarkeit und/oder die Möglichkeit zur Darstellung von Anzeigen bei gleichzeitiger Prozessbeobachtung möglich sind.

Gelöst wird diese Aufgabe durch die kennzeichnenden Merkmale des Anspruch 1. Weiterbildungen der Erfindung ergeben sich aus den Unteransprüchen.

Gemäß der Erfindung ist vorgesehen, dass zumindest ein Teil der Steuereinrichtung für eine Druckmaschine mit wenigstens einem Bedien- oder Anzeigeelement direkt auf einer durchsichtigen Scheibe angeordnet wird. Dies ermöglicht die einfache und bequeme Bedienbarkeit und Ablesbarkeit der Elemente bei gleichzeitig möglicher Prozessbeobachtung.
Gemäß einer bevorzugten Ausführungsform der Erfindung ist vorgesehen, dass die Bedienbarkeit am Ausleger durch die Anordnung wenigstens eines der Bedien- und Anzeigeelemente auf der Scheibe vereinfacht wird. Das Auslösen eines Feuchtstoßes in bestimmten Druckwerken kann hier während der Beobachtung des Prozesses durchgeführt werden. Der Maschinenbediener muss seinen Platz der Beobachtung nicht verlassen. Er kann direkt vor Ort den Feuchtstoß auslösen oder die Einstellungen der Maschine verändern. Hierzu sind die Bedienelemente als mechanische Taste zwischen zwei Glasplatten oder als kapazitiver Sensor hinter der Glasplatte ausgeführt. Die Anzeigeelemente, als Leuchtdiode oder als Elektrolumineszens-Folie ausgeführt, zeigen die Dauer des Feuchtstoßes an.

Da die Leiterbahnen zu den Elementen zumindest teilweise transparent ausgeführt sind, wird das Blickfeld kaum eingeschränkt. Auch die nicht aktivierten Elektrolumineszens-Folien sind transparent.

Erfindungsgemäß werden die anderen Bedien- und Anzeigeelemente ebenfalls teilweise transparent ausgeführt, so dass auch hier die Sicht auf den ablaufenden Prozess nicht erheblich eingeschränkt wird.
Sind die Bedienelemente komplett transparent, so wird eine Markierung zu deren Kennzeichnung in Form eines Rahmens oder Symbols angebracht.

Eine weitere Möglichkeit ein Anzeigeelement anzuordnen, ist die Ausführung eines elektrostatischen Lautsprechers hinter der Scheibe.

Die Erfindung kann sowohl am Ausleger als auch am Anleger oder an den Stellen der Druckmaschine, an denen sich Scheiben zum Zwecke der Beobachtung befinden, realisiert werden.

Des weiteren erfolgt die Erläuterung einer Ausführungsbeispiels der Erfindung anhand der Zeichnungen. Es zeigt:
- Fig. 1: einen Ausleger einer Bogendruckmaschine mit einer erfindungsgemäß ausgebildeten Steuereinrichtung und
- Fig. 2: eine Glasscheibe mit den erfindungsgemäß darauf angeordneten Bedien- und Anzeigeelementen.

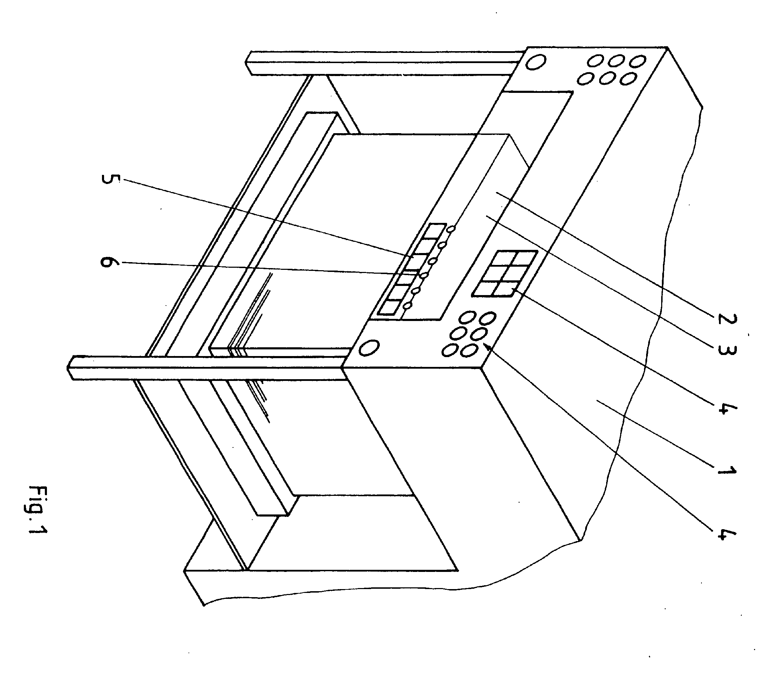

Fig. 1 zeigt einen Ausleger 1 einer nicht dargestellten Bogendruckmaschine in perspektivischer Ansicht.
In dem Überbau des Auslegers 1 befindet sich das Sichtfenster 2, dass zur Prozessbeobachtung (Ablage des Bogens auf dem Stapel) dient. Es ist aus Sicherheitsgründen mit einer durchsichtigen Scheibe 3 abgedeckt. Die Bedien- und Anzeigeelemente 4 für eine Vielzahl von Funktionen der Druckmaschine sind in bekannter Art und Weise um das Sichtfenster 2 mit der Scheibe 3 angeordnet.
Gemäß der Erfindung sind die Bedienelemente 5 und die Anzeigeelemente 6 für spezielle Funktionen in der Glasscheibe angeordnet.

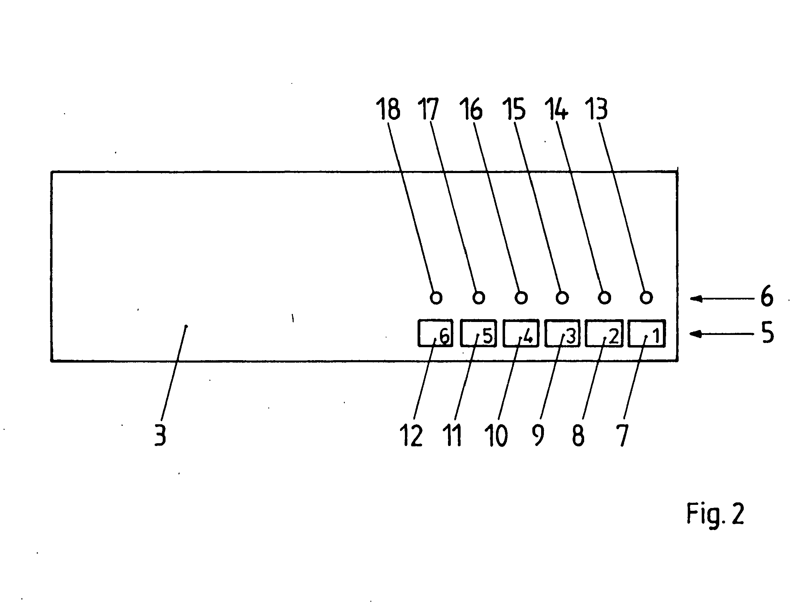

Fig. 2 zeigt die Scheibe 3 mit den darin angeordneten Bedienelementen 5 und den Anzeigeelementen 6. Die Bedienelemente 7 bis 12 sind als kapazitive Sensoren hinter der Scheibe 3 ausgeführt und 6 Druckwerken (nicht dargestellt) zugeordnet. Die Leuchtdioden 13 bis 18 sind den darunter angeordneten Bedienelementen, also ebenfalls den 6 Druckwerken, zugeordnet.
Wird das Bedienelement 7 betätigt, wird der Feuchtstoß im ersten Druckwerk (nicht dargestellt) ausgelöst und die Leuchtdiode 13 zeigt die Dauer des Feuchtstoßes an.
Wird das Bedienelement 11 betätigt, wird der Feuchtstoß im fünften Druckwerk (nicht dargestellt) ausgelöst und die Leuchtdiode 17 zeigt die Dauer des Feuchtstoßes an.

### [Bezugszeichenliste]

- 1: Ausleger
- 2: Sichtfenster
- 3: Scheibe
- 4: Bedien- und Anzeigeelemente
- 5: Bedienelemente
- 6: Anzeigeelemente
- 7-12: Bedienelement als kapazitiver Sensor ausgeführt
- 13-18: Leuchtdiode

## Patentansprüche

1. Druckmaschine mit einer Steuereinrichtung mit manuell durch Berührung betätigbaren Bedienelementen (5) und Anzeigeelementen (6) sowie eines mittels einer durchsichtigen Scheibe (3) abgedeckten Sichtfensters (2),
**dadurch gekennzeichnet,**
**dass** wenigstens ein Element (5, 6) als aktivierbarer Bereich der Scheibe (3) ausgebildet ist, dass Bedienelemente (5) und Anzeigeelemente (6) wenigstens teilweise transparent ausgebildet sind, und dass die Bedienelemente (5) und Anzeigeelemente (6) an der Scheibe (3), die ein der Prozessbeobachtung dienendes Sichtfenster (2) aus Sicherheitsgründen abdeckt, an einem Ausleger (1) und/oder an einem Anleger der Druckmaschine angeordnet sind.

2. Druckmaschine nach Anspruch 1,
**dadurch gekennzeichnet,**
**dass** zwei Scheiben (3) vorgesehen sind, zwischen denen ein Anzeigeelement (6) als Leuchtdiode (13-18) ausgeführt ist.

3. Druckmaschine nach Anspruch 1 bis 2,
**dadurch gekennzeichnet,**
**dass** ein Anzeigeelement (6) als Elektrolumineszens-Folie (EL-Folie) ausgeführt ist.

4. Druckmaschine nach Anspruch 1,
**dadurch gekennzeichnet,**
**dass** ein Anzeigeelement (6) als elektrostatischer Lautsprecher hinter der Scheibe (3) ausgeführt ist.

## Claims

1. A printing machine with a control device with operating elements (5) and display elements (6) that can be actuated manually through touch as well as a view window (2) covered by means of a transparent pane (3),
**characterized in**
**that** at least one element (5, 6) is embodied as activatable region of the pane (3), that operating elements (5) and display elements (6) are embodied at least partially transparently and that the operating elements (5) and display elements (6) on the pane (3) which covers a view window (2) serving for the process observation for safety reasons are arranged on a delivery (1) and/or on a feeder of the printing machine.

2. The printing machine according to Claim 1,
**characterized in**
**that** two panes (3) are provided between which a display element (6) is embodied as light-emitting diode (13-18).

3. The printing machine according to Claim 1 to 2,
**characterized in**
**that** a display element (6) is embodied as electroluminescence foil (EL foil).

4. The printing machine according to Claim 1,
**characterized in**
**that** a display element (6) is embodied as electrostatic loudspeaker behind the pane (3).

## Revendications

1. Machine d'impression comportant un dispositif de commande doté d'éléments de manoeuvre (5) actionnables par contact et des éléments d'affichage (6) ainsi qu'une fenêtre de visualisation (2) recouverte par une vitre transparente (3),
**caractérisé en ce que**
l'au moins un élément (5, 6) est réalisé sous forme d'une zone activable de la vitre (3), que les éléments de manoeuvre (5) et les éléments d'affichage (6) ont une conformation au moins partiellement transparente et que les éléments de manoeuvre (5) et les éléments d'affichage (6) sont disposés sur la vitre (3) qui recouvre pour des raisons de sécurité une fenêtre de visualisation (2) servant à observer le processus et ce au niveau d'une console (1) et/ou d'un margeur de la machine d'impression.

2. Machine d'impression selon la revendication 1,
**caractérisée en ce que**
il est prévu deux vitres (3) entre lesquelles un élément d'affichage (6) est réalisé sous forme de diode électroluminescente (13-18).

3. Machine d'impression selon la revendication 1 ou 2,
**caractérisée en ce que**
un élément d'affichage (6) est réalisé sous forme de film électroluminescent (film EL).

4. Machine d'impression selon la revendication 1,
**caractérisée en ce que**
un élément d'affichage (6) est réalisé sous forme de haut-parleur électrostatique derrière la vitre (3).
